Europäisches Patentamt

(19) European Patent Office

Office européen des brevets

(11) Veröffentlichungsnummer: **0 085 914**
**B1**

(12) # EUROPÄISCHE PATENTSCHRIFT

(45) Veröffentlichungstag der Patentschrift:
20.05.87

(51) Int. Cl.⁴: **C 04 B 37/02, B 23 K 35/38**

(21) Anmeldenummer: **83100601.6**

(22) Anmeldetag: **28.01.83**

(54) **Verfahren zum direkten Verbinden von Kupferstücken mit Oxidkeramiksubstraten.**

(30) Priorität: **06.02.82 DE 3204167**

(43) Veröffentlichungstag der Anmeldung:
**17.08.83 Patentblatt 83/33**

(45) Bekanntmachung des Hinweises auf die Patenterteilung:
**20.05.87 Patentblatt 87/21**

(84) Benannte Vertragsstaaten:
**CH DE FR GB LI NL**

(56) Entgegenhaltungen:
**EP-A-0 049 007**
**GB-A-761 045**
**GB-A-1 084 417**
**GB-A-2 059 323**
**US-A-3 994 430**

**Journal of the Electrochemical Society, 1975, vol. 722, S. 688-690**

(73) Patentinhaber: **BROWN, BOVERI & CIE Aktiengesellschaft, Kallstadter Strasse 1, D-6800 Mannheim 31 (DE)**

(72) Erfinder: **Bunk, Klaus, Paulusstrasse 3, D-6520 Worms (DE)**
Erfinder: **Neidig, Arno, Dr. Dipl.- Phys., Brühlerweg 42, D-6831 Plankstadt (DE)**
Erfinder: **Wahl, Georg, Dr. Dipl.- Phys., Franz- List- Strasse 9, D-6901 Eppelheim (DE)**
Erfinder: **Keser, Helmut, Hinterhofstrasse 382, CH-5242 Birr (CH)**

(74) Vertreter: **Kempe, Wolfgang, Dr., c/o BROWN, BOVERI & CIE AG ZPT Postfach 351, D-6800 Mannheim 31 (DE)**

## Beschreibung

Die Erfindung bezieht sich auf ein Verfahren zum direkten Verbinden von Metallstücken mit Oxidkeramiksubstraten gemäß dem Oberbegriff des Anspruchs 1.

Ein solches Verfahren ist aus der DE-OS 25 08 224 bekannt. Bei diesem Verfahren wird voroxidiertes Metall verwendet, um auch bei großflächigen Verbindungen eine Haftung an allen Stellen zwischen Metall und Keramik zu ermöglichen. Außerdem wird das Metallstück so vorgebogen, daß es sich während des Erhitzens nur allmählich auf das Keramiksubstrat legt. Dadurch sollen etwaige Gasblasen zwischen Metall und Keramik nach außen herausgedrückt werden. Dieses Verfahren ist jedoch aufwendig und umständlich; auch ist, wenn das Metallstück und/oder das Keramiksubstrat kompliziert vorgeformt sind, ein Biegen des Metallstückes nicht immer möglich oder das Metallstück legt sich nicht genügend gleichmäßig auf das Substrat. Außerdem überzieht sich bei der zu verwendenden reaktionsfähigen Atmosphäre aus etwa 0,01 bis 0,5 Vol.-% Sauerstoff (Rest Stickstoff) die freiliegende Metallfläche während des Erhitzens mit einer Oxidschicht, die nachträglich erst wieder beseitigt werden muß.

Aus der DE-OS 26 33 869 ist ein Verfahren bekannt, bei dem eine Metallfolie, bevorzugt aus Kupfer, zunächst oxidiert wird, worauf die Metallfolie mit der Oxidschicht in Kontakt mit einem Oxidkeramiksubstrat, bevorzugt aus Aluminium- oder Berylliumoxid, gebracht wird. Danach werden Metallfolie und Substrat in einer inerten Atmosphäre bei einer Temperatur zwischen der eutektischen Temperatur von Kupfer und Kupferoxid und der Schmelztemperatur von Kupfer solange erhitzt, bis sich eine untereutektische Schmelze zwischen Kupfer und dem Substrat gebildet hat. Erhitzen in inerter Atmosphäre führt jedoch nicht zu der gewünschten haftfesten Verbindung zwischen Kupfer und Keramik, da sich bei den gegebenen Verfahrenstemperaturen CuO zu $Cu_2O$ und $Cu_2O$ zu Cu reduziert, wenn nicht in der umgebenden Atmosphäre ein gewisser minimaler Sauerstoff-Partialdruck aufrecht erhalten wird. Reduziertes Cu verbindet sich jedoch nicht mit Keramik.

In der DE-OS 26 33 869 wird auch vorgeschlagen, anstelle eines voroxidierten Kupfers ein sauerstoffhaltiges Kupfermaterial ohne Oxidüberzug zu verwenden. Abgesehen davon, daß auch hierbei keine Bindung zwischen Kupfer und Keramik entstehen kann, wenn nicht ein Mindestsauerstoffpartialdruck in der Ofenatmosphäre aufrechterhalten bleibt, hat es sich bei Versuchen herausgestellt, daß der im Metall gelöste Sauerstoff an die Berührungsfläche zwischen Kupfer und Keramik diffundiert und dort eingeschlossen bleibt, was zur Bildung von Gasblasen und damit zu einer fehlerhaften Bindung zwischen Metall und Keramik führt.

Aus der DE-OS 23 19 854 ist ein weiteres Verfahren zum direkten Verbinden von Metallen mit nichtmetallischen Substraten bekannt, das sich von dem soeben beschriebenen Verfahren dadurch unterscheidet, daß eine blanke, nicht voroxidierte Metallfolie, insbesondere aus Kupfer, in reaktiver, insbesondere sauerstoffhaltiger Atmosphäre mit dem Oxidkeramiksubstrat verbunden werden soll. Bei diesem Verfahren muß der Sauerstoff in der Atmosphäre zunächst das Kupfer oberflächlich oxidieren, bevor der eigentliche Verbindungsprozeß ablaufen kann. Es hat sich jedoch herausgestellt, daß insbesondere bei großflächigen Verbindungen zwischen Keramik und Kupfer der Sauerstoff nicht in ausreichender Menge in den Spalt zwischen Keramik und Kupfer eindringen kann, so daß blasenartige Stellen ohne Haftung entstehen. Außerdem wird bei den angegebenen Sauerstoffmengen von 0,01 bis 0,5Vol.-% die Kupferfolie auf der vom Keramiksubstrat abgewendeten Seite mit einer dicken, schwarzen Kupferoxidschicht überzogen, die in einem zusätzlichen Arbeitsgang wieder entfernt werden muß, bevor eine Weiterverarbeitung, insbesondere in der Halbleiter-Industrie, möglich ist. Von einem Sauerstoffanteil unter 0,01 Vol.-% wird ausdrücklich abgeraten, da dann keine Bindung zwischen Kupfer und Keramik zustandekomme.

Ein solches Verfahren also mit nicht schon oberflächlich voroxidierten Kupferteilen, ist auch in Journal of the Elektrochemical Society 1975, seiten 688 bis 690, insbesondere Seiten 689, linke Spalte, letzter Absatz und rechte Spalte, erster Absatz angegeben. Auch hier wird ein hoher Sauerstoffanteil (a few hundreth of a per cent) in der Atmosphäre vogeschlagen, der ebenfalls zu der genannten dicken Kupferoxidschicht führt, die in einem zusätzlichen Arbeitsgang entfert werden muß. Außerdem wird wegen der Verwendung von blanken Kupferteilen darauf hingewiesen, daß bei einem Sauerstoffpartialdruck von unter 0,0015 mbar (entspricht 1,5 vpm) kein Kupferoxid und damit auch keine eutekrische Kupfer-Kupferoxid-Schmelzr gebildet wird.

Aus der GB-PS 761 045 ist ebenfalls ein Verfahren zum direktenn Verbinden von Kupfer mit Keramik bekannt. Dort wird eine Vielzahl von Verfahrensvarianten beschrieben, bei denen die Ofenatmosphäre wenigstens zeitweise einen oxidierenden und weningstens zeitweise einen reduzierenden Druck besitzt. Auch das Erhitzen im Vakuum wird vorgeschlagen. Allen Verfahrensvarianten ist gemeinsam, daß die Verbindung von Kupfer und Keramik in einem Temperaturbereich von 1083°C bis 1235°C stattfinden soll, d.h. oberhalb der Schmelztemperatur von Kupfer und unterhalb der Schmelztemperatur von Kupferoxid. Die Bildung von übermäßig dicken Oxidschichten auf den freien Kupferflächen soll dabei durch eine Maskierung mit einem schützenden Material wie Aluminiumoxid oder Silber verhindert werden.

Die Aufbringung und nachfolgende Entfernung des schützenden Materials bedingt jedoch zusätzliche Verfahrensschritte. Ferner ist der notwendige Temperaturbereich in nachteiliger Weise sehr hoch.

Der Erfindung liegt die Aufgabe zugrunde, ein verbessertes Verfahren zum direkten Verbinden von Metallstücken mit Oxidkeramiksubstraten zu schaffen, bei dem auf infache Weise eine weitgehende blasenfreie Verbindung zwischen den stücken und den Keramiksubstraten und gleichzeitig eine oxidfreie Metalloberfläche erzielt wird.

Diese Aufgabe wird durch die im Anspruch 1 gekennzeichneten Merkmale gelöst.

Die mit der Erfindung erzielbaren Vorteile bestehen insbesondere darin, daß lediglich durch geeignete Verfahrensführung und ohne nachträgliche Reduktionsschritte eine oxidfreie Metalloberfläche erhalten wird. Das Verfahren ist zudem für eine wirtschaftliche Massenfertigung geeignet. Eine Nachbehandlung der dem Durchlaufofen entnommenen Metall-Keramik-Verbundsvsteme für die Weiterverarbeitung ist nicht erforderlich.

Vorteilhafte Ausgestaltungen der Erfindung sind in den Unteransprüchen gekennzeichnet.

Die Erfindung wird nachstehend anhand eines Ausführungsbeispiels erläutert.

Es zeigen:

Fig. 1 den Aufbau eines zur Durchführung des Verfahrens geeigneten Durchlaufofens,

Fig. 2 das Temperaturprofil im Durchlaufofen.

Vor der Durchführung des eigentlichen Verfahrens werden die Metallstücke, vorzugsweise Kupferbleche, mit einer Oxidschicht versehen. Die Dicke des Oxids sollte etwa 1/10 der Oberflächenrauhigkeit der verwendeten Keramiksubstrate, z.B. Aluminiumoxidkeramik, entsprechen. Das Oxidieren erfolgt vorzugsweise chemisch. Die Kupferbleche können ein- oder beidseitig oxidiert sein und werden mit ihrer oxidierten Seite flach auf die Keramiksubtrate gelegt. Zum Ausgleich der Durchbiegung und Wölbung durch thermische Spannungen aufgrund der unterschiedlichen Wärmedehnung von Kupfer und Keramik können Kupferbleche auf beiden Seiten der Keramiksubstrate vorgesehen sein.

Die Kupferbleche werden vorzugsweise aus sauerstoffreiem Kupfer hergestellt und müssen planeben sein. Ferner dürfen sie keinen Grat an den Schnittkanten aufweisen. Andernfalls kann kein genügend enger Kontakt zwischen den oxidierten Kupferblechen und den Keramiksubstraten zustandekommen.

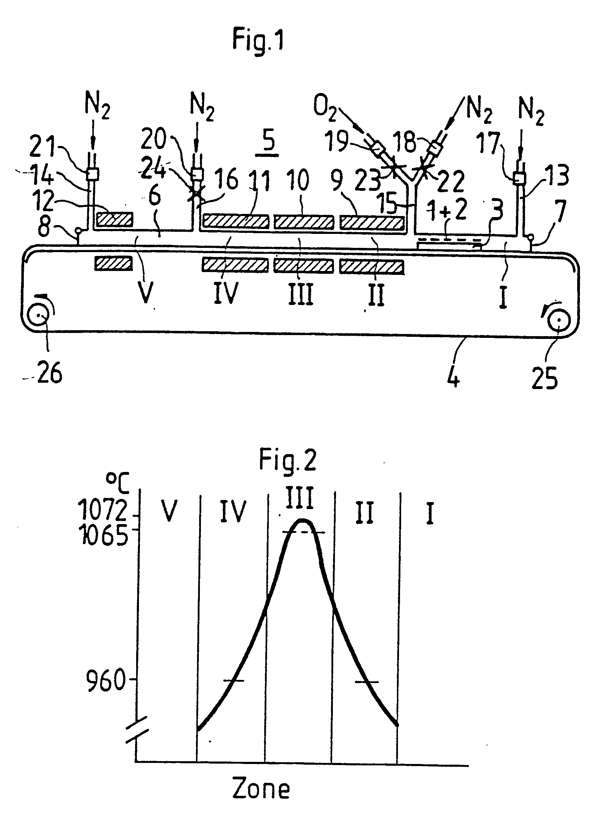

Wie in Fig. 1 dargestellt, werden die mit Kupferblechen 1 versehenen Substrate 2 flach auf einen Träger 3, vorzugsweise aus Siliziumkarbid oder aus einem Graphitkern mit einer Siliziumkarbid-Beschichtung gelegt. Der Träger 3 wird auf die Transportkette 4 eines Durchlaufofens 5 gestellt.

Der Durchlaufofen 5 besitzt einen beidseitig offenen Tunnel (Metallschacht) 6. Im Tunnel 6 treten im wesentlichen fünf räumlich verteilte Temperaturzonen auf, nämlich eine Erwärmungszone I im Eingangsteil, drei Heizzonen II, III, IV im Mittelteil und eine Abkühlzone V im Ausgangsteil des Tunnels. Beide offenen Enden des Tunnels 6 sind mit beweglich angebrachten, nicht gasdichten Schleusen (Metallklappen) 7, 8 versehen. Das Mittelstück des Tunnels 6 wird von drei Heizelementen 9, 10, 11 zur Schaffung der Heizzonen II, III, IV umschlossen. An seinem ausgangsseitigen Endstück besitzt der Tunnel ein seine Wandung umgebendes Kühlelement 12. Die mit Hilfe der drei Heizelemente 10, 11, 12 konstant zu haltenden Temperaturwerte im Tunnelinneren sind unabhängig voneinander vorgebbar und werden mit einer Genauigkeit von 1 bis 20 geregelt.

Der Tunnel 6 weist ferner an seinen beiden Enden Gaseinlaßstutzen 13 und 14 auf. Weitere Gaseinlaßstutzen 15 bzw. 16 befinden sich vor dem ersten Heizelement 9 bzw. nach dem dritten Heizelement 11. Der Gaseinlaßstutzen 15 gabelt sich und mündet in zwei Gaszuleitungen. Zur genauen Einstellung der Gasvolumenströme sind Durchflußmesser 17, 20, 21 an den Gaseinlaßstutzen 13, 16, 14 vorgesehen. Weitere Durchflußmesser 18, 19 befinden sich im Zuge der beiden Gaszuleitungen zum Gaseinlaßstutzen 15. Diese beiden Gaszuleitungen besitzen zusätzliche Regelventile 22, 23 zur genauen Regelung der vorgegebenen Volumenströme. Ein derartiges Regelventil 24 ist auch für den Gaseinlaßstutzen 16 vorgesehen.

Die endlose Transportkette 4 des Durchlaufofens 5 wird über Walzen 25, 26 angetrieben. Der auf der Kette 4 vor dem Tunneleingang liegende Träger 3 gelangt durch die sich öffnende Schleuse 7 in die Erwärmungszone I im Eingangsteil des Tunnelinneren. Durch den im Tunnel hinter der Schleuse 7 angeordneten Gaseinlaßstutzen 13 wird Stickstoff geblasen, der einen Gasschleier bildet und damit ein Eindringen von sauerstoffreicher Außenluft (insbesondere beim Öffnen der Schleuse 7) in das Tunnelinnere verhindert.

Die mit Kupferblechen 1 belegten Substrate 2 durchlaufen auf dem Träger 3 liegend die Erwärmungszone I sowie die Heizzone II in ca. 20 Minuten. Der mittlere Abschnitt der Heizzone II wird ungefähr auf einen Temperaturwert T = 960° C geregelt. Bei Eintritt in den mittleren Abschnitt der Heizzone III erreichen die zu verbindenden Teile eine Temperatur zwischen der eutektischen Temperatur (1065° C) von Kupfer und Kupferoxid und der Schmelztemperatur (1083° C) von Kupfer, also vorzugsweise einen Temperatur-Scheitelwert von 1070° C bis 1072° C, und es bildet sich eine eutektische Schmelze zwischen dem Kupferblech 1 und dem Keramiksubstrat 2.

Die mit Kupfer belegten Substrate verbleiben während des Durchlaufens für ca. 1 bis 2 Minuten in dieser Hochtemperatur-Reaktionszone. Im Tunnelinneren herrscht in der Erwärmungszone I sowie in den Heizzonen II und III eine Stickstoff-Atmosphäre mit einem Sauerstoff-Zusatz von 20 bis 50 vpm. Zur Aufrechterhaltung dieser Atmosphäre wird durch den Gaseinlaßstutzen 15 ständig das vorgegebene Stickstoff/Sauerstoff-Gemisch geblasen, wobei Durchflußmesser 19/Regelventil 23 für die Sauerstoffzufuhr und Durchflußmesser 18/Regelventil 22 für die Stickstoffzufuhr vorgesehen sind.

Das Gemisch verteilt sich infolge Verwirbelung gleichmäßig in den Zonen I, II, III und verläßt den Tunnel 6 über die Schleuse 7.

Nach Beendigung des Verbindungsprozesses, d.h. Verfestigung der eutektischen Schmelze, tritt der auf der Kette 4 durchlaufende Träger 3 von der Heizzone III in die Heizzone IV des Tunnels 6 ein. Die Metall-Keramik-Verbundsysteme sind im mittleren Abschnitt der Heizzone IV bereits auf ca. 960°C abgekühlt. Die Abkühlung der Metall-Keramik-Verbundsysteme in der Heizzone IV und der nachfolgenden eigentlichen Abkühlzone V findet in einer reinen Stickstoffatmosphäre statt. Bei Verwendung beidseitig oxidierter Kupferbleche 1 reduziert sich dabei die Kupferoberfläche. Die Stickstoffatmosphäre wird durch Einblasen von reinem Stickstoff über den Gaseinlaßstutzen 16 in das Tunnelinnere erzielt. Der Stickstoff verteilt sich infolge Verwirbelung gleichmäßig in den Zonen IV und V und verläßt den Tunnel 6 über die Schleuse 8.

Durch spezielle Düsenanordnungen bzw. -formen an den Gaseinlaßstutzen 15 und 16 sowie durch entsprechende Einstellung der Volumenströme durch beide Einlaßstutzen ist eine relativ scharfe Grenze zwischen der Stickstoff/Sauerstoff-Atmosphäre in den Zonnen I, II, III und der reinen Stickstoffatmosphäre in den Zonen IV und V ohne zusätzliche Schleusen im Tunnelinneren einstellbar.

Der gesamte Abkühlprozeß dauert etwa 20 Minuten. Zur beschleunigten Abkühlung der Metall/Keramik-Verbundsysteme dient das Kühlelement 12 am Ende des Tunnels, das beispielsweise wassergekühlt ist. Durch den Gaseinlaßstutzen 14 wird wiederum Stickstoff zur Bildung eines Gasschleiers geblasen, was ein Eindringen von Außenluft in das Tunnelinnere (insbesondere beim Öffnen der Schleuse 8) verhindert. Beim Verlassen des Durchlaufofens 5 durch die Schleuse 8 sind die Metall-Keramik-Verbundsysteme auf Raumtemperatur abgekühlt. Die Kupferoberflächen sind metallisch blank und oxidieren praktisch nicht nach. Ein etwaiger Oxidanteil ist so gering, daß er bei einem nachfolgenden Lötvorgang durch übliche Flußmittel leicht beseitigt werden kann. Die Haftung des Kupfers an der Keramik ist weitgehend blasenfrei und so gut, daß bei Abzugsversuchen Teile der Keramik mit dem Kupfer abgerissen werden.

In Fig. 2 ist das sich in den einzelnen Zonen des Durchlaufofens 5 einstellende Temperaturprofil dargestellt. Die Temperaturachse T zeigt dabei lediglich den oberen Temperaturbereich von ca. 960°C bis 1072°C. Aus der Fig. 2 ist insbesondere das relativ steil ansteigende bzw. abfallende Temperaturprofil in den Heizzonen II, III, IV ersichtlich. Der zur Erzeugung der eutektischen Schmelze wichtige Temperaturbereich oberhalb 1065°C wird nur im mittleren Abschnitt der Heizzone III erreicht. Der beidseitige Abfall des Temperaturprofils von der Maximaltemperatur 1072°C auf die in den Mittelteilen der Heizzonen II und IV vorgegebenen Temperaturen von T = 960°C ist steil, d.h. Erwärmung und Abkühlung der Metall-Keramik-Verbundsysteme erfolgen im Temperaturbereich von 960°C bis 1072°C sehr rasch. Durch diese Verfahrensführung (in Verbindung mit der angegebenen Stickstoff/Sauerstoff-Atmosphäre) werden insbesondere die weitgehend blasenfreien Metall-Keramik-Verbundsysteme mit blanker Metalloberfläche erzielt.

**Patentansprüche**

1. Verfahren zum direkten Verbinden von Kupferstücken, die eine durch oberfläche Oxidation hergestellte Kupferoxidschicht tragen, mit Oxidkeramiksubstraten durch Erhitzen der mit den Kupferstücken belegten Keramiksubstrate in sauerstoffhaltiger Atmosphäre bis zu einer Temperatur oberhalb der eutektischen Temperatur des Kupfers und des Oxids, jedoch unterhalb der Schmelztemperatur des Kupfers, dadurch gekennzeichnet, daß das Erhitzen in einem Durchlaufofen in einer Stickstoff-Atmosphäre mit einem Sauerstoffzusatz von 20 bis 50 vpm (volume per million) durchgeführt wird und das Abkühlen im Durchlaufofen nach Verfestigung der eutektischen Schmelze in einer reinen Stickstoff-Atmosphäre erfolgt.

2. Verfahren nach Anspruch 1, dadurch gekennzeichnet, daß sowohl das Erhitzen als auch das Abkühlen der zu verbindenden Teile im oberen Temperaturbereich rasch erfolgt.

3. Verfahren nach einem der vorstehenden Ansprüche, dadurch gekennzeichnet, daß als Kupferstücke Kupferbleche verwendet werden, die chemisch voroxidiert wurden.

4. Verfahren nach einem der vorstehenden Ansprüche, dadurch gekennzeichnet, daß als Oxidkeramiksubstrate Aluminiumoxide verwendet werden.

5. Verfahren nach einem der vorstehenden Ansprüche, dadurch gekennzeichnet, daß Kupferstücke verwendet werden, deren Oxidschicht bei der Voroxidation auf eine Dicke eingestellt wurde, die etwa 1/10 der Oberflächenrauhigkeit der Keramiksubstrate entspricht.

## Claims

1. Process for the direct connection of copper parts, which carry a copper oxide layer produced by surface oxidation, to oxide ceramic substrates by heating of the ceramic substrates covered with the copper parts in an oxygen-containing atmosphere up to a temperature above the eutectic temperature of the copper and of the oxide but below the melting point of the copper, characterized in that the heating is carried out in a continuous-heating furnace in a nitrogen atmosphere with an oxygen supplement of 20 to 50 vpm (volume per million), and the cooling takes place in the continuous-heating furnace after solidification of the eutectic melt in a pure nitrogen atmosphere.

2. Process according to Claim 1, characterized in that both the heating and also the cooling of the parts to be connected take place rapidly in the upper temperature range.

3. Process according to one of the preceding Claims, characterized in that copper sheets which have been chemically preoxidized are employed as copper parts.

4. Process according to one of the preceding Claims, characterized in that aluminium oxides are employed as oxide ceramic substrates.

5. Process according to one of the preceding Claims, characterized in that copper parts are employed, the oxide layer of which has been set in the course of the preoxidation to a thickness which corresponds to approximately 1/10 of the surface roughness of the ceramic substrates.

## Revendications

1. Procédé pour assembler directement des pièces en cuivre, portant une couche d'oxyde de cuivre produite par oxydation superficielle, à des substrats en céramique d'oxyde, en chauffant ces substrats en céramique sur lesquels sont pesées les pièces en cuivre, dans une atmosphère contenant de l'oxygène, jusqu'à une température supérieure à la température eutectique du cuivre et de l'oxyde, mais inférieure à la température de fusion du cuivre, caractérisé en ce que le chauffage est effectué dans un four tunnel, dans une atmosphère d'azote avec une addition d'oxygène de 20 à 50 vpm (volumes par million), et le refroidissement a lieu dans le four tunnel, après solidification de l'eutectique liquide, dans une atmosphère d'azote pur.

2. Procédé selon revendication 1, caractérisé en ce que le chauffage des pièces à assembler, tout aussi bien que leur refroidissement, est réalisé rapidement dans le domaine des températures élevées.

3. Procédé selon l'une quelconque des revendications précédentes, caractérisé en ce que l'on utilise, comme pièces en cuivre, des feuilles en cuivre qui sont préoxydées chimiquement.

4. Procédé selon l'une quelconque des revendications précédentes, caractérisé en ce que l'on utilise, comme substrats en céramique d'oxyde, des oxydes d'aluminium.

5. Procédé selon l'une quelconque des revendications précédentes, caractérisé en ce que l'on utilise des pièces en cuivre dont la couche d'oxyde, lors de l'oxydation préalable, a été réglée à une épaisseur qui correspond à environ 1/10 de la rugosité de surface des substrats en céramique.

## Fig.1

## Fig.2